(19) Europäisches Patentamt
European Patent Office
Office européen des brevets

(11) **EP 4 267 978 B1**

(12) **EUROPEAN PATENT SPECIFICATION**

(45) Date of publication and mention
of the grant of the patent:
**20.05.2026 Bulletin 2026/21**

(21) Application number: **21840258.4**

(22) Date of filing: **07.12.2021**

(51) International Patent Classification (IPC):
**G01R 31/392** (2019.01)    G01R 31/382 (2019.01)
**G01R 31/396** (2019.01)

(52) Cooperative Patent Classification (CPC):
**G01R 31/392;** G01R 31/382; G01R 31/396

(86) International application number:
**PCT/US2021/062190**

(87) International publication number:
**WO 2022/146626 (07.07.2022 Gazette 2022/27)**

(54) **SYSTEM AND METHOD OF DETERMINATION OF ELECTROCHEMICAL CELL FADE**

SYSTEM UND VERFAHREN ZUR BESTIMMUNG DES AUSBLEICHENS ELEKTROCHEMISCHER ZELLEN

SYSTÈME ET PROCÉDÉ DE DÉTERMINATION DE L'ÉVANOUISSEMENT D'UNE CELLULE ÉLECTROCHIMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2020 US 202063131073 P**
**17.11.2021 US 202117528424**

(43) Date of publication of application:
**01.11.2023 Bulletin 2023/44**

(73) Proprietor: **Medtronic, Inc.**
**Minneapolis, Minnesota 55432 (US)**

(72) Inventors:
• **JI, Gang**
**Minneapolis, Minnesota 55432 (US)**
• **SCHMIDT, Craig L.**
**Minneapolis, Minnesota 55432 (US)**
• **ARTMANN, Joel B.**
**Minneapolis, Minnesota 55432 (US)**
• **ZHANG, Bo**
**Minneapolis, Minnesota 55316 (US)**

(74) Representative: **Zimmermann & Partner Patentanwälte mbB**
**P.O. Box 330 920**
**80069 München (DE)**

(56) References cited:
WO-A1-2011/162014     WO-A1-2017/098686
CN-A- 109 541 490     US-A1- 2009 228 225
US-A1- 2020 203 780

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD

The present disclosure relates to, among other things, electrochemical cells; and particularly to fade modeling of electrochemical cells.

TECHNICAL BACKGROUND

Electrochemical cells can be used in a variety of medical equipment such as ventilators, surgical staplers, medical monitoring equipment, etc. Some electrochemical cells can be recharged to allow repeated use of the electrochemical cells and extend the useful life of such electrochemical cells. However, over time and with repeated use, the electrochemical cells experience a reduction in capacity. CN109541490A relates to a battery service life estimating method, a system and a vehicle. WO 2011/162014 A1 relates to a battery management apparatus, method of reusing a battery, and an information communication terminal apparatus. US 2020/203780 A1 relates to a method and system for predicting onset of capacity fading in a battery. WO 2017/098686 A1 relates to a battery pack, electricity storage device and deterioration detecting method. US 2009/0228225 A1 relates to battery service life estimation methods, apparatus and computer program products using state estimation techniques initialized using regression model.

SUMMARY

The invention provides a method according to independent claim 1 and a system according to claim independent 11. Advantageous embodiments are defined by the dependent claims. The method involves monitoring a capacity of at least one electrochemical cell. A current fade rate us determined based on the capacity. The current fade rate is compared to at least one previously determined fade rate. A fault counter is adjusted based on the comparison.
The system comprises a controller and a memory storing computer program instructions which when executed by the controller cause the controller to perform operation. The operations comprise monitoring a capacity of at least one electrochemical cell. A current fade rate us determined based on the capacity. The current fade rate is compared to at least one previously determined fade rate. A fault counter is adjusted based on the comparison.
A method involves monitoring a capacity of at least one electrochemical cell. A current fade rate is determined based on the capacity. It is determined if the current fade rate is greater than at least one previously determined fade rate. A fault counter is incremented if it is determined that the current fade rate is greater than the at least one previously determined fade rate. The fault counter is decremented if it is determined that the current fade rate is less than or equal to the at least one previously determined fade rate.
Advantages and additional features of the subject matter of the present disclosure will be set forth in the detailed description which follows, and in part will be readily apparent to those skilled in the art from that description or recognized by practicing the subject matter of the present disclosure as described herein, including the detailed description which follows, the claims, as well as the appended drawings.
It is to be understood that both the foregoing general description and the following detailed description present embodiments of the subject matter of the present disclosure, and are intended to provide an overview or framework for understanding the nature and character of the subject matter of the present disclosure as it is claimed. The accompanying drawings are included to provide a further understanding of the subject matter of the present disclosure and are incorporated into and constitute a part of this specification. The drawings illustrate various embodiments of the subject matter of the present disclosure and together with the description serve to explain the principles and operations of the subject matter of the present disclosure. Additionally, the drawings and descriptions are meant to be merely illustrative and are not intended to limit the scope of the claims in any manner.

BRIEF DESCRIPTION OF THE DRAWINGS

The following detailed description of specific embodiments of the present disclosure can be best understood when read in conjunction with the following drawings, in which:

FIG. 1 is a schematic block diagram of an embodiment of an electrochemical cell charging apparatus and a device in accordance with embodiments described herein;

FIG. 2 is a schematic block diagram of an embodiment of an electrochemical cell charging apparatus in accordance with embodiments described herein;

FIG. 3 shows a high-level battery system for determining a battery condition in accordance with embodiments described herein.

FIG. 4 shows a flow diagram to determine a current battery condition in accordance with embodiments describe herein;

FIG. 5 shows a more detailed flow diagram to determine a current battery condition in accordance with embodiments describe herein; and

FIG. 6 shows a flow diagram to determines a current battery condition using a comparison of current and previous fade rates in accordance with embodiments describe herein.

The figures are not necessarily to scale unless otherwise indicated. Like numbers used in the figures refer to like components. However, it will be understood that the use of a number to refer to a component in a given figure is not intended to limit the component in another figure labeled with the same number.

DETAILED DESCRIPTION

Reference will now be made in greater detail to various embodiments of the subject matter of the present disclosure, some embodiments of which are illustrated in the accompanying drawings. Like numbers used in the figures refer to like components and steps. However, it will be understood that the use of a number to refer to a component in a given figure is not intended to limit the component in another figure labeled with the same number. In addition, the use of different numbers to refer to components in different figures is not intended to indicate that the different numbered components cannot be the same or similar to other numbered components.

As the rechargeable battery ages, its capacity and impedance increase. Depending on the battery usage, such as calendar time, average voltage, charging profile, patient load etc., the environment factors, such as ambient temperature, and the battery-to-battery variability, the actual fade rate of battery may vary significantly. The fade rate of battery may be useful in identifying the potential fault condition and end-of-service condition. Therefore, it is desired to have the ability in the device to measure the fade rate of battery in the field and subsequently use it to determine the condition of battery. Embodiments described herein involve a method and system to measure and update the fade rate of battery as the battery ages. It is to be understood that electrochemical cell and battery may be used interchangeably.

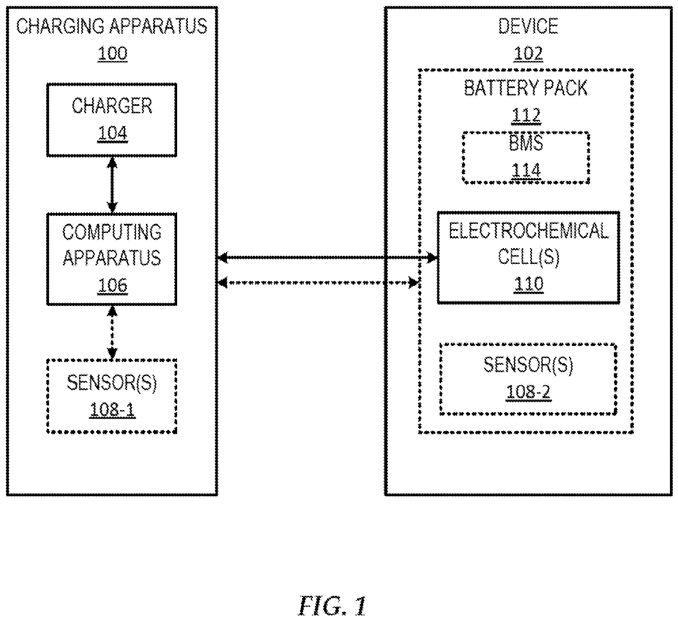

Referring now to **FIG. 1,** a schematic block diagram of a charging apparatus **100** and a device **102** is shown. The charging apparatus **100** includes a charger **104** and a computing apparatus **106**. The charging apparatus **100** may optionally include one or more sensors **108-1.** The charger **100** may include a housing (not shown) to house the charger **104** and the computing apparatus 106. The housing may also house the sensors **108-1.** According to various embodiments, the charging apparatus 100 may optionally be located inside the device 102.

The device **102** includes one or more electrochemical cells **110**. The electrochemical cells **110** can optionally be included in a battery pack **112**. The battery pack **112** may include a battery management system (BMS) **114** and one or more sensors **108-2**. The device **102** may be a medical device. The medical device may be a ventilator, surgical stapler, or medical monitoring equipment, for example.

The charger **104** may be configured to charge the electrochemical cells **110** or battery pack **112**. The charger **104** may include any suitable circuitry or electronics to charge the electrochemical cells **110** or battery pack **112** such as, e.g., a power source, rectifier circuit, power circuit, control circuit, regulator circuit, fault detection circuit, etc.

The computing apparatus **106** may be operatively coupled to the charger **104**. The computing apparatus **106** may control the charger to charge the electrochemical cells **110**. The computing apparatus **106** may be operatively coupled to the sensors **108-1.** The computing apparatus may be configured to monitor various conditions related to charging the electrochemical cells **110** such as, e.g., charging current, voltage, temperature, etc. Additionally, the computing apparatus **106** may be configured to determine a state of health of the electrochemical cells **110** according to the various methods described herein.

The electrochemical cells **110** may include any suitable type or chemistry such as, e.g., nickel metal hydride, lithium ion, lead acid, Lithium Cobalt Oxide, etc. The electrochemical cells **110** are rechargeable electrochemical cells. The electrochemical cells **110** may have any suitable voltage, capacity, supply current, etc. The electrochemical cells **110** may be incorporated into a battery pack **112**.

The battery pack **112** may include a plurality of electrochemical cells **110**. The electrochemical cells **110** can be arranged in parallel, series, or a combination thereof. The battery pack **112** may include the BMS **114** to monitor the electrochemical cells **110,** maintain safe operating conditions of the electrochemical cells, reporting various conditions of the electrochemical cells, etc. The battery pack **112** may further include sensors **108-2** to sense temperature, voltage, current, etc.

The sensors **108-1, 108-2** (referred to collectively as sensors **108**) may include any suitable sensor or sensors such as, e.g., temperature sensors, current sensors, voltage sensors, state of charge sensors, etc. The sensors **108** may provide a sensed temperature signal, sensed current signal, sensed voltage signal, sensed state of charge signal, etc. The signals provided by the sensors 108 may be indicative of the properties sensed by the sensors.

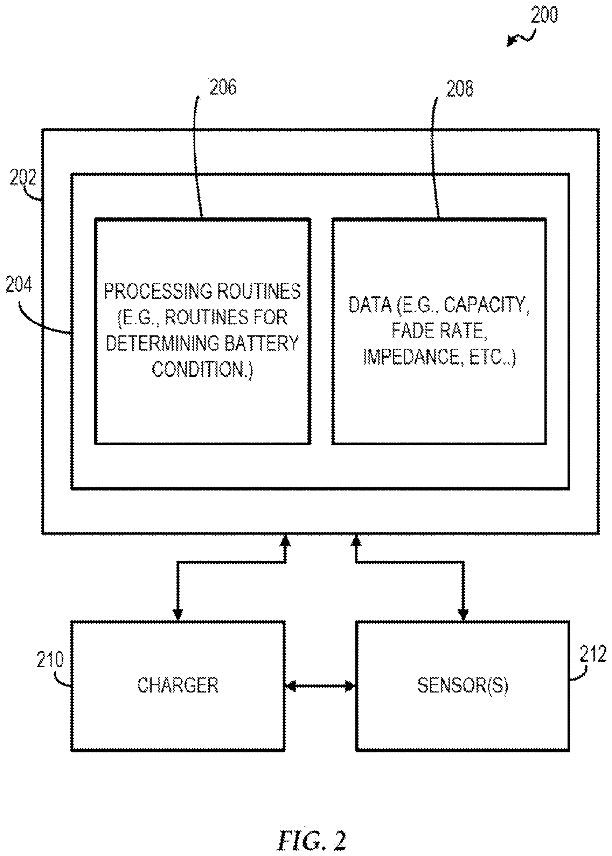

Referring now to **FIG. 2,** a schematic block diagram of a system **200** according to embodiments described herein is shown. The charging apparatus **200** may include a computing apparatus or processor **202** and a charger **210.** Generally, the charger **210** may be operably coupled to the computing apparatus **202** and may include any suitable circuits or devices configured charge electrochemical cells. For example, the charger **210** may include one or more power sources, rectifier circuits, power circuits, control circuits, regulator circuits, fault detection circuits, etc.

The system **200** may additionally include one or more sensors 212 operably coupled to the computing apparatus **202.** Generally, the sensors **212** may include any one or more devices configured to sense charging information of the charger 210 or electrochemical cells. The sensors **212** may include any apparatus, structure, or device to capture the charging information of the charger such as one or more current sensors, voltage sensors, temperature sensors, etc.

Further, the computing apparatus **202** includes data storage **204**. Data storage **204** allows for access to processing programs or routines **206** and one or more other types of data **208** that may be employed to carry out the techniques, processes, and algorithms of determining whether an electrochemical cell is in danger of failing. For example, processing programs or routines **206** may include programs or routines for determining a charging current, determining a temperature difference, determining a frequency of recharge, determining a state of health of an electrochemical cell, computational mathematics, matrix mathematics, Fourier transforms, compression algorithms, calibration algorithms, image construction algorithms, inversion algorithms, signal processing algorithms, normalizing algorithms, deconvolution algorithms, averaging algorithms, standardization algorithms, comparison algorithms, vector mathematics, analyzing sound data, analyzing hearing device settings, detecting defects, or any other processing required to implement one or more embodiments as described herein.

Data 208 may include, for example, temperature data, voltage data, charging current data, state of health data, state of charge data, thresholds, arrays, meshes, grids, variables, counters, statistical estimations of accuracy of results, results from one or more processing programs or routines employed according to the disclosure herein (e.g., determining a state of health of an electrochemical cell, etc.), or any other data that may be necessary for carrying out the one or more processes or techniques described herein.

In one or more embodiments, the system **200** may be controlled using one or more computer programs executed on programmable computers, such as computers that include, for example, processing capabilities (e.g., microcontrollers, programmable logic devices, etc.), data storage (e.g., volatile or non-volatile memory and/or storage elements), input devices, and output devices. Program code and/or logic described herein may be applied to input data to perform functionality described herein and generate desired output information. The output information may be applied as input to one or more other devices and/or processes as described herein or as would be applied in a known fashion.

The programs used to implement the processes described herein may be provided using any programmable language, e.g., a high-level procedural and/or object orientated programming language that is suitable for communicating with a computer system. Any such programs may, for example, be stored on any suitable device, e.g., a storage media, readable by a general or special purpose program, computer or a processor apparatus for configuring and operating the computer when the suitable device is read for performing the procedures described herein. In other words, at least in one embodiment, the system 200 may be controlled using a computer readable storage medium, configured with a computer program, where the storage medium so configured causes the computer to operate in a specific and predefined manner to perform functions described herein.

The system **202** may be, for example, any fixed or mobile computer system (e.g., a personal computer or minicomputer). The exact configuration of the computing apparatus is not limiting and essentially any device capable of providing suitable computing capabilities and control capabilities (e.g., control the sound output of the charging apparatus 200, the acquisition of data, such as image data, audio data, or sensor data) may be used. Additionally, the computing apparatus **202** may be incorporated in a housing of the system **200.** Further, various peripheral devices, such as a computer display, mouse, keyboard, memory, printer, scanner, etc. are contemplated to be used in combination with the computing apparatus 202. Further, in one or more embodiments, the data **208** (e.g., battery capacity, fade rate, and/or impedance) may be analyzed by a user, used by another machine that provides output based thereon, etc. As described herein, a digital file may be any medium (e.g., volatile or non-volatile memory, a CD-ROM, a punch card, magnetic recordable tape, etc.) containing digital bits (e.g., encoded in binary, trinary, etc.) that may be readable and/or writeable by computing apparatus **202** described herein. Also, as described herein, a file in user-readable format may be any representation of data (e.g., ASCII text, binary numbers, hexadecimal numbers, decimal numbers, audio, graphical) presentable on any medium (e.g., paper, a display, sound waves, etc.) readable and/or understandable by a user.

In view of the above, it will be readily apparent that the functionality as described in one or more embodiments according to the present disclosure may be implemented in any manner as would be known to one skilled in the art. As such, the computer language, the computer system, or any other software/hardware that is to be used to implement the processes described herein shall not be limiting on the scope of the systems, processes or programs (e.g., the functionality provided by such systems, processes or programs) described herein.

The techniques described in this disclosure, including those attributed to the systems, or various constituent components, may be implemented, at least in part, in hardware, software, firmware, or any combination thereof. For example, various aspects of the techniques may be implemented by the computing apparatus **202,** which may use one or more processors such as, e.g., one or more microprocessors, DSPs, ASICs, FPGAs, CPLDs, microcontrollers, or any other equivalent integrated or discrete logic circuitry, as well as any combinations of such components, image processing devices, or other devices. The term "processing apparatus," "processor," or "processing circuitry" may generally refer to any of the foregoing logic circuitry, alone or in combination with other logic circuitry, or any other equivalent circuitry. Additionally, the use of the word "processor" may not be limited to the use of a single processor but is intended to connote that at least one processor may be used to perform the techniques and processes described herein.

Such hardware, software, and/or firmware may be implemented within the same device or within separate devices to support the various operations and functions described in this disclosure. In addition, any of the described components may be implemented together or separately as discrete but interoperable logic devices. Depiction of different features, e.g., using block diagrams, etc., is intended to highlight different functional aspects and does not necessarily imply that such features must be realized by separate hardware or software components. Rather, functionality may be performed by separate hardware or software components or integrated within common or separate hardware or software components.

When implemented in software, the functionality ascribed to the systems, devices and techniques described in this disclosure may be embodied as instructions on a computer-readable medium such as RAM, ROM, NVRAM, EEPROM, FLASH memory, magnetic data storage media, optical data storage media, or the like. The instructions may be executed by the computing apparatus **202** to support one or more aspects of the functionality described in this disclosure.

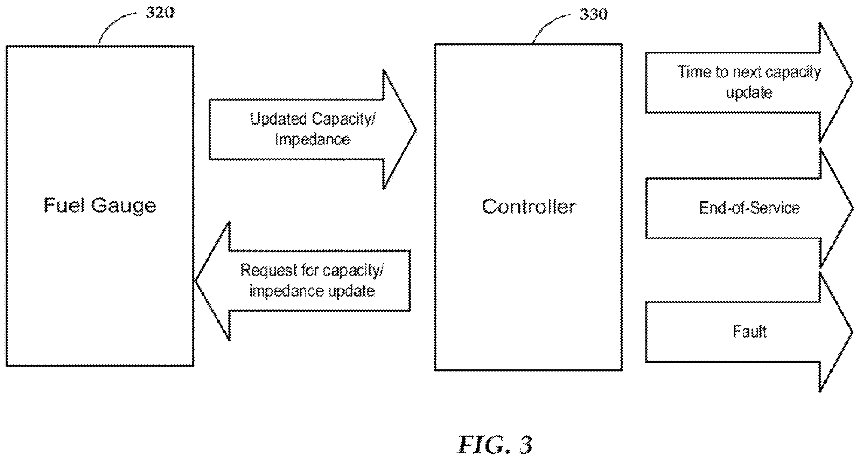

**FIG. 3** shows a high-level battery system for determining a condition of one or more electrochemical cells in accordance with embodiments described herein. A controller **330** requests one or more of a current capacity and/or an impedance from the fuel gauge **320.** The controller **330** receives the updated capacity and/or impedance and uses this information to determine a condition of the battery. For example, the controller may determine the time to the next capacity update based on the updated capacity and/or the impedance. According to various embodiments, the controller **330** is configured to send one or more flags based on a condition of the battery. For example, the controller may be configured to issue an end-of-service (EOS) flag and/or one or more fault flags based on the updated capacity and/or the impedance.

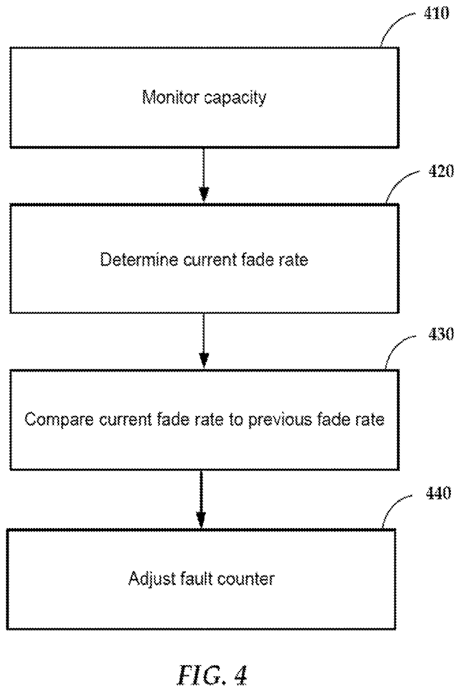

Referring now to **FIG. 4,** a method for determining a condition of one or more electrochemical cells accordance with embodiments described herein is shown. A capacity of at least one electrochemical cell is monitored **410.** The at least one electrochemical cell may be monitored using the one or more sensors described herein. According to various implementations, the capacity of the at least one electrochemical cell is monitored continuously. In some embodiments, the controller of the at least one electrochemical cell receives capacity updates periodically. For example, the capacity may be updated regularly at discrete intervals of time. In some cases, the capacity is updated based on a previous capacity, a previous impedance, and or a determined fade rate of the one or more electrochemical cells.

A current fade rate may be determined **420** based on the monitored capacity. The current fade rate may be based on one or more determined capacity measurements. The current fade rate is compared **430** to at least one previously determined fade rate. A fault counter is adjusted **440** based on the comparison.

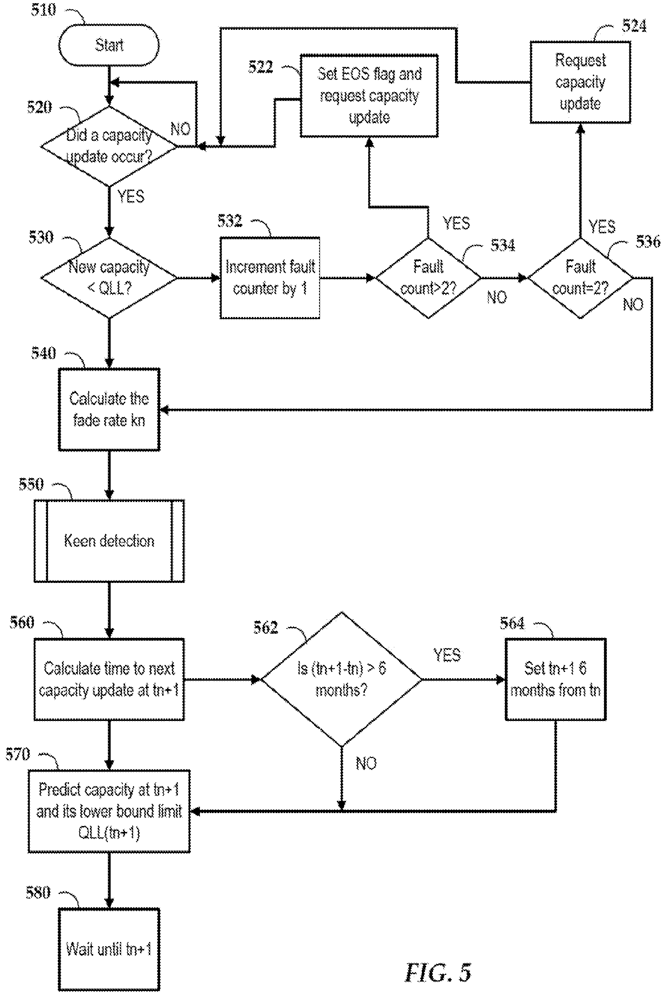

**FIG. 5** shows a more detailed method for determining a condition of at least one electrochemical cell in accordance with embodiments described herein. The process starts **510** and the system monitors for a capacity update.

Once it is determined **520** that a capacity update has occurred, it is determined **530** whether the new capacity is less than a predetermined lower bound, QLL. If it is determined **530** that the new capacity is not less than the predetermined lower bound, the process continues with calculating **540** the fade rate. If it is determined **530** that the new capacity is less than the predetermined lower bound, a fault counter is incremented **532** by 1.

It is determined **534** whether the fault counter is greater than a threshold (e.g., 2). If it is determined **534** that the fault counter is greater than the predetermined threshold, an EOS flag is set and a request for a capacity update is sent **522** to the fuel gauge. The process continues with determining **520** whether a capacity update has occurred. If it is determined **534** that the fault counter is not greater than the predetermined threshold, it is determined **536** whether the fault counter is equal to the predetermined threshold. If it is determined **536** that the fault counter is equal to the predetermined threshold, a capacity update is requested **524** and the process continues with determining **520** whether a capacity update has occurred. If it is determined **536** is not equal to the predetermined threshold (i.e., is less than the predetermined threshold), the current fade rate is calculated (1) **540.** The current fade rate is based on an incremental fade model that is based on calendar time and is calculated using (1).

$$k_n = \frac{Q_{max}(t_{n-1}) - Q_{max}(t_n)}{t_n - t_{n-1}}$$

Here, $k_n$ is the fade rate calculated from the prior two Qmax values updated at $t_{n-1}$ and $t_n$. One set of parameters may be used for each cell to track the individual fade rate. According to various implementations, the capacity is modeled and tracked at the cell level to detect capacity imbalance.

According to various implementations described herein, a similar flow as to the capacity update shown in **FIG. 5** may be used for impedance updates as well. For example, using an impedance value instead of the capacity value may be used in (1).

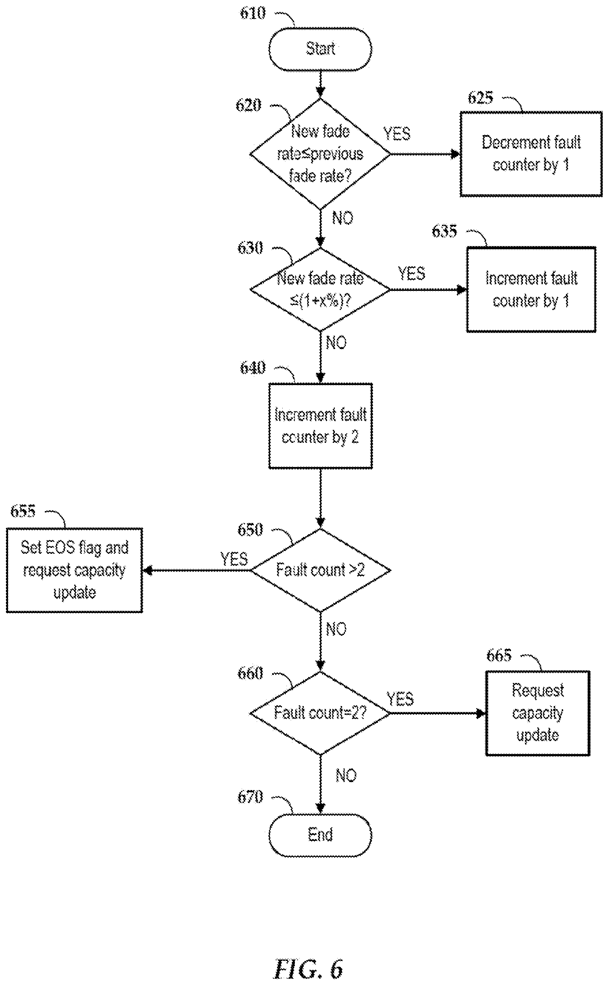

After a current fade rate is calculated, knee detection **550** begins. An example of the knee detection subroutine is described in more detail in the description of FIG. 6. The time to the next capacity update at tn+1 (with tn being the current capacity update time) is calculated **560** as shown in (2).

$$t_{n+1} - t_n = \frac{x * Q_{max}(t_n)}{k_n}$$

$$if\ t_{n+1} - t_n > 6\ months, set\ t_{n+1} - t_n = 6\ months \tag{2}$$

Here, $t_{n+1}$ is the time point when the next Qmax update is may be scheduled for the given cell. $t_{n+1}$ of pack = min ($t_{n+1}$ cell1, $t_{n+1}$ cell2, $t_{n+1}$ cell3, $t_{n+1}$ cell4) and the device FW will generate the condition flag at $t_{n+1}$ of pack. The patient and/or clinician can be notified what $t_{n+1}$ of pack is for planning purposes.

It is determined **562** whether tn+1-tn is greater than a predetermined time interval (e.g., 6 months). If tn+1-tn is greater than the predetermined time interval, the time for the next capacity update is set **564** to the predetermined time interval. If it is determined that tn+1-tn is not greater than the predetermined time interval, the capacity at tn+1 is predicted according to (3) and its associated lower bound limit is predicted

$$Q_{predict}(t_{n+1}) = Q_{max}(t_n) - k_n * (t_{n+1} - t_n)$$

The lower limit $Q_{LL}(t_{n+1})$ for the coming Qmax at $t_{n+1}$ is calculated according to (3) (4). This might need to be bounded by the confidence level y.

$$Q_{LL}(t_{n+1}) = Q_{predict}(t_{n+1}) * y \tag{4}$$

The system then waits **580** until the next capacity update at tn+1 before starting again with determining **520** whether a capacity update has occurred. At $t_{n+1}$, after the Qmax update in the field is completed, the device FW read the new Qmax $Q_{max}(t_{n+1})$ from BMS and resets the condition flag. The new $Q_{max}(t_{n+1})$ may be checked against the lower limit $Q_{LL}(t_{n+1})$. If $Q_{max}(t_{n+1}) < Q_{LL}(t_{n+1})$, the Qmax_fault counter may be incremented by 1. **FIG. 6** shows a method for determining a condition of at least one electrochemical cell based on a comparison of fade rates in accordance with embodiments described herein. The (5) process starts **610** and it is determined **620** whether the current fade rate, $k_{n+1}$, is less than or equal to a previous fade rate, kn. The current $k_{n+1}$ based on $Q_{max}(t_{n+1})$ may be calculated based on (5).

$$k_{n+1} = \frac{Q_{max}(t_n) - Q_{max}(t_{n+1})}{t_{n+1} - t_n}$$

If $k_{n+1}$ exceeds $k_n$ by the predefined thresholds, the knee on the capacity fade curve is detected. For example, if it is determined **620** that the current fade rate is less than or equal to the previous fade rate as shown in (6), a fault counter is decremented **625** by 1 and the system continues with determining **650** whether the fault counter is greater than a predetermined value.

$$\frac{k_{n+1}}{k_n} \leq 1.0\ (reducing\ fade\ rate)$$

If it is determined **620** that the current fade rate is greater than the previous (6) fade rate, it is determined **630** whether the current fade rate is less than or equal to a predetermined threshold (e.g., 1+x%). If it is determined **630** that the new fade rate is less than or equal to the predetermined threshold as shown in (7), the fault counter is incremented by 1 and the method continues with determining **650** if the fault counter is greater than the predetermined threshold.

$$(1 + x\%) \geq \frac{k_{n+1}}{k_n} > 1.0 \; (slightly \; increasing \; fade \; rate) \qquad (7)$$

If it is determined 630 that the current fade rate is greater than the predetermined value as shown in (8), the fault counter is incremented **640** by 2.

$$\frac{k_{n+1}}{k_n} > (1 + x\%) \; (significantly \; increasing \; fade \; rate) \qquad (8)$$

It is determined **650** if the fault counter is greater than the predetermined threshold. If it is determined **650** that the fault counter is greater than the predetermined threshold, the EOS flag is set, a capacity update is requested **655,** and the process ends **670.** If it is determined **650** that the fault counter is not greater than the predetermined threshold, it is determined **660** whether the fault counter is equal to the predetermined threshold. If it is determined **660,** that the fault counter is not equal to the predetermined threshold the process ends **670.** If it is determined **660** that the fault counter is equal to the predetermined threshold, a capacity update is requested **665.**

All scientific and technical terms used herein have meanings commonly used in the art unless otherwise specified. The definitions provided herein are to facilitate understanding of certain terms used frequently herein and are not meant to limit the scope of the present disclosure.

As used herein, singular forms "a," "an" and "the" include plural referents unless the context clearly dictates otherwise. As used in this specification and the appended claims, the term "or" is generally employed in its sense including "and/or" unless the content clearly dictates otherwise. The term "and/or" means one or all of the listed elements or a combination of any two or more of the listed elements.

The words "preferred" and "preferably" refer to embodiments of the disclosure that may afford certain benefits, under certain circumstances. However, other embodiments may also be preferred, under the same or other circumstances. Furthermore, the recitation of one or more preferred embodiments does not imply that other embodiments are not useful and is not intended to exclude other embodiments from the scope of the inventive technology.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that any particular order be inferred. Any recited single or multiple feature or aspect in any one claim can be combined or permuted with any other recited feature or aspect in any other claim or claims.

It will be apparent to those skilled in the art that various modifications and variations can be made to the present inventive technology without departing from the scope of the disclosure. Since modifications, combinations, sub-combinations and variations of the disclosed embodiments incorporating the substance of the inventive technology may occur to persons skilled in the art, the inventive technology should be construed to include everything within the scope of the appended claims.

## Claims

1. A method, comprising:

  monitoring (410) a capacity of at least one electrochemical cell;
  determining (420) a current fade rate based on the capacity;
  comparing (430) the current fade rate to at least one previously determined fade rate; and
  adjusting (440) a fault counter based on the comparison, **characterized in that** :
  adjusting the fault counter based on the determination comprises:

    incrementing the fault counter if it is determined that the current fade rate is greater than the at least one previously determined fade rate; and
    decrementing the fault counter if it is determined that the current fade rate is less than or equal to the at least one previously determined fade rate.

2. The method of claim 1, further comprising:

   determining if the current fade rate is greater than the at least one previously determined fade rate; and adjusting the fault counter based on the determination.

3. The method of claim 1, further comprising determining if the fault counter is greater than a predetermined threshold.

4. The method of claim 3, further comprising if it is determined that the fault counter is greater than the predetermined threshold, generating an end of service flag and requesting for a capacity update.

5. The method of claim 3, further comprising if it is determined that the fault counter is less than or equal to the predetermined threshold, requesting a capacity update.

6. The method of claim 1, further comprising determining a time for a capacity update of the at least one electro chemical cell based on the current fade rate.

7. The method of claim 1, further comprising:
   determining if the current fade rate is greater than at least one previously determined fade rate.

8. The method of claim 7, further comprising determining if the fault counter is greater than a predetermined threshold.

9. The method of claim 8, further comprising if it is determined that the fault counter is greater than the predetermined threshold, generating an end of service flag and requesting for a capacity update.

10. The method of claim 8, further comprising if it is determined that the fault counter is less than or equal to the predetermined threshold, requesting a capacity update.

11. A system, comprising:

    a controller; and
    a memory storing computer program instructions which when executed by the controller cause the controller to perform a method according to any one of claims 1-10.

12. The system of claim 11, further comprising a battery pack, wherein the battery pack comprises:

    a plurality of electrochemical cells the plurality of electrochemical cells comprising the at least one electrochemical cell; and
    a battery management apparatus operatively coupled to the controller comprising one or more sensors to sense one or more of a voltage, a state of charge, a charging current, and a temperature of each of the plurality of electrochemical cells.

13. The system of claim 11, wherein the at least one electrochemical cell is disposed in a medical device.


**Patentansprüche**

1. Verfahren, umfassend:

   Überwachen (410) einer Kapazität mindestens einer elektrochemischen Zelle;
   Bestimmen (420) einer aktuellen Fading-Rate (Kapazitätsverlustrate) basierend auf der Kapazität;
   Vergleichen (430) der aktuellen Fading-Rate mit mindestens einer zuvor bestimmten Fading-Rate; und
   Einstellen (440) eines Fehlerzählers basierend auf dem Vergleich, **dadurch gekennzeichnet, dass**:
   Einstellen des Fehlerzählers basierend auf der Bestimmung umfasst:

   Inkrementieren des Fehlerzählers, falls bestimmt wird, dass die aktuelle Fading-Rate größer als die mindestens eine zuvor bestimmte Fading-Rate ist; und
   Dekrementieren des Fehlerzählers, falls bestimmt wird, dass die aktuelle Fading-Rate kleiner oder gleich der mindestens einen zuvor bestimmten Fading-Rate ist.

**2.** Verfahren nach Anspruch 1, ferner umfassend:

Bestimmen, ob die aktuelle Fading-Rate größer als die mindestens eine zuvor bestimmte Fading-Rate ist; und Einstellen des Fehlerzählers basierend auf der Bestimmung.

**3.** Verfahren nach Anspruch 1, ferner umfassend Bestimmen, ob der Fehlerzähler größer als eine vorbestimmte Schwelle ist.

**4.** Verfahren nach Anspruch 3, ferner umfassend, falls bestimmt wird, dass der Fehlerzähler größer als die vorbestimmte Schwelle ist, Generieren eines "Ende der Nutzungsdauer"-Flags und Anfordern einer Kapazitätsaktualisierung.

**5.** Verfahren nach Anspruch 3, ferner umfassend Anfordern einer Kapazitätsaktualisierung, falls bestimmt wird, dass der Fehlerzähler kleiner oder gleich der vorbestimmten Schwelle ist.

**6.** Verfahren nach Anspruch 1, ferner umfassend Bestimmen einer Zeit für eine Kapazitätsaktualisierung der mindestens einen elektrochemischen Zelle basierend auf der aktuellen Fading-Rate.

**7.** Verfahren nach Anspruch 1, ferner umfassend:
Bestimmen, ob die aktuelle Fading-Rate größer als mindestens eine zuvor bestimmte Fading-Rate ist.

**8.** Verfahren nach Anspruch 7, ferner umfassend Bestimmen, ob der Fehlerzähler größer als eine vorbestimmte Schwelle ist.

**9.** Verfahren nach Anspruch 8, ferner umfassend, falls bestimmt wird, dass der Fehlerzähler größer als die vorbestimmte Schwelle ist, Generieren eines "Ende der Nutzungsdauer"-Flags und Anfordern einer Kapazitätsaktualisierung.

**10.** Verfahren nach Anspruch 8, ferner umfassend Anfordern einer Kapazitätsaktualisierung, falls bestimmt wird, dass der Fehlerzähler kleiner oder gleich der vorbestimmten Schwelle ist.

**11.** System, umfassend:

eine Steuerung; und
einen Speicher, der Computerprogrammanweisungen speichert, die, wenn sie durch die Steuerung ausgeführt werden, die Steuerung veranlassen, ein Verfahren nach einem der Ansprüche 1-10 durchzuführen.

**12.** System nach Anspruch 11, ferner umfassend ein Batteriepack, wobei das Batteriepack umfasst:

eine Vielzahl von elektrochemischen Zellen, wobei die Vielzahl von elektrochemischen Zellen die mindestens eine elektrochemische Zelle umfasst; und
eine Batteriemanagementeinrichtung, die operativ mit der Steuerung gekoppelt ist, die einen oder mehrere Sensoren umfasst, um ein oder mehrere von einer Spannung, einem Ladezustand, einem Ladestrom und einer Temperatur von jeder der Vielzahl von elektrochemischen Zellen abzufühlen.

**13.** System nach Anspruch 11, wobei die mindestens eine elektrochemische Zelle in einer medizinischen Vorrichtung angeordnet ist.


**Revendications**

**1.** Procédé, comprenant :

la surveillance (410) d'une capacité d'au moins une cellule électrochimique,
la détermination (420) d'une vitesse d'évanouissement de courant sur la base de la capacité ;
la comparaison (430) de la vitesse d'évanouissement de courant à au moins une vitesse d'évanouissement déterminée précédemment ; et
l'ajustement (440) d'un compteur de défauts sur la base de la comparaison, **caractérisé en ce que** :
l'ajustement du compteur de défauts sur la base de la détermination comprend :

l'incrémentation du compteur de défauts s'il est déterminé que la vitesse d'évanouissement de courant est supérieure à l'au moins une vitesse d'évanouissement déterminée précédemment ; et
la décrémentation du compteur de défauts s'il est déterminé que la vitesse d'évanouissement de courant est inférieure ou égale à l'au moins une vitesse d'évanouissement déterminée précédemment.

**2.** Procédé selon la revendication 1, comprenant en outre :

la détermination si la vitesse d'évanouissement de courant est supérieure à l'au moins une vitesse d'évanouissement déterminée précédemment ; et
l'ajustement du compteur de défauts sur la base de la détermination.

**3.** Procédé selon la revendication 1, comprenant en outre la détermination si le compteur de défauts est supérieur à un seuil prédéterminé.

**4.** Procédé selon la revendication 3, comprenant en outre, s'il est déterminé que le compteur de défauts est supérieur au seuil prédéterminé, la génération d'un indicateur de fin de service et la demande d'une mise à jour de capacité.

**5.** Procédé selon la revendication 3, comprenant en outre, s'il est déterminé que le compteur de défauts est inférieur ou égal au seuil prédéterminé, la demande d'une mise à jour de capacité.

**6.** Procédé selon la revendication 1, comprenant en outre la détermination d'un temps pour une mise à jour de capacité de l'au moins une cellule électrochimique sur la base de la vitesse d'évanouissement de courant.

**7.** Procédé selon la revendication 1, comprenant en outre :
la détermination si la vitesse d'évanouissement de courant est supérieure à au moins une vitesse d'évanouissement déterminée précédemment.

**8.** Procédé selon la revendication 7, comprenant en outre la détermination si le compteur de défauts est supérieur à un seuil prédéterminé.

**9.** Procédé selon la revendication 8, comprenant en outre, s'il est déterminé que le compteur de défauts est supérieur au seuil prédéterminé, la génération d'un indicateur de fin de service et la demande d'une mise à jour de capacité.

**10.** Procédé selon la revendication 8, comprenant en outre, s'il est déterminé que le compteur de défauts est inférieur ou égal au seuil prédéterminé, la demande d'une mise à jour de capacité.

**11.** Système, comprenant :

un dispositif de commande ; et
une mémoire stockant des instructions de programme informatique qui, lorsqu'elles sont exécutées par le dispositif de commande, amènent le dispositif de commande à réaliser un procédé selon l'une quelconque des revendications 1 à 10.

**12.** Système selon la revendication 11, comprenant en outre un bloc-batterie, le bloc-batterie comprenant :

une pluralité de cellules électrochimiques, la pluralité de cellules électrochimiques comprenant l'au moins une cellule électrochimique ; et
un appareil de gestion de batterie couplé de manière fonctionnelle au dispositif de commande comprenant un ou plusieurs capteurs pour détecter un ou plusieurs parmi une tension, un état de charge, un courant de charge et une température de chacune de la pluralité de cellules électrochimiques.

**13.** Système selon la revendication 11, l'au moins une cellule électrochimique étant disposée dans un dispositif médical.

*FIG. 1*

11

*FIG. 2*

*FIG. 3*

410

Monitor capacity

420

Determine current fade rate

430

Compare current fade rate to previous fade rate

440

Adjust fault counter

*FIG. 4*

*FIG. 5*

*FIG. 6*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109541490 A
- WO 2011162014 A1
- US 2020203780 A1
- WO 2017098686 A1
- US 20090228225 A1